# EUROPEAN PATENT APPLICATION

(11) **EP 4 525 586 A1**
(43) Date of publication of application: **19.03.2025**
(21) Application number: 24198751.0
(22) Date of filing: 05.09.2024
(51) Int. Cl.: H10D 89/10, H10D 30/62, H10D 84/01

(54) **INTEGRATED CIRCUITS INCLUDING ACTIVE PATTERNS WITH VARIOUS WIDTHS AND METHODS OF DESIGNING THE INTEGRATED CIRCUITS**

(30) Priority: 18.09.2023 KR 20230124274; 18.01.2024 KR 20240008299
(71) Applicant: Samsung Electronics Co., Ltd, Suwon-si, Gyeonggi-do 16677 (KR)
(72) Inventor: NAM, Kibum, 16677 Suwon-si (KR); LEE, Bonghyun, 16677 Suwon-si (KR)
(74) Representative: Marks & Clerk LLP

(57) **Abstract**

An integrated circuit comprising: a plurality of first gate electrodes extending in a second direction perpendicular to a first direction, wherein the plurality of first gate electrodes is in a first row that extends in the first direction; a first active pattern group comprising a plurality of first active patterns that extend in the first row in the first direction and intersecting the plurality of first gate electrodes; a plurality of second gate electrodes extending in the second direction in a second row that extends in the first direction; and a second active pattern group comprising a plurality of second active patterns extending in the second row in the first direction and intersecting the plurality of second gate electrodes, wherein ones of the plurality of first active patterns have different widths in the second direction, and the plurality of second active patterns have a first width in the second direction.

## Description

### BACKGROUND OF THE INVENTION

The inventive concept relates to integrated circuits, and more particularly, to integrated circuits including active patterns with various widths and methods of designing the integrated circuits.

Due to the development of semiconductor processes, devices having various structures have been developed, and each of the devices may have specific characteristics. New devices may be formed by new sub-processes, and accordingly, new design rules for designing integrated circuits including the new devices may be required.

### SUMMARY OF THE INVENTION

The inventive concept provides integrated circuits including active patterns with various widths and methods of designing the integrated circuits.

According to an aspect of the inventive concept, there is provided an integrated circuit including a plurality of first gate electrodes extending in a second direction that is perpendicular to a first direction, wherein the plurality of first gate electrodes is in a first row that extends in the first direction; a first active pattern group comprising a plurality of first active patterns that extend in the first row in the first direction and intersecting the plurality of first gate electrodes; a plurality of second gate electrodes extending in the second direction in a second row that extends in the first direction; and a second active pattern group comprising a plurality of second active patterns that extend in the second row in the first direction and intersecting the plurality of second gate electrodes, wherein ones of the plurality of first active patterns have different widths in the second direction, and wherein ones of the plurality of second active patterns have a first width in the second direction.

According to another aspect of the inventive concept, there is provided an integrated circuit including a plurality of first cells in a first row that extends in a first direction; and a plurality of second cells in a second row that extends in the first direction, wherein the plurality of first cells comprise respective ones of a plurality of first active patterns extending in the first direction, wherein the plurality of second cells comprise respective ones of a plurality of second active patterns extending in the first direction, wherein ones of the plurality of first active patterns have different widths in a second direction that is perpendicular to the first direction, and wherein ones of the plurality of second active patterns each have a first width in the second direction..

According to another aspect of the inventive concept, there is provided a method of manufacturing an integrated circuit including a plurality of cells, the method including obtaining a netlist defining the plurality of cells; and placing the plurality of cells in a plurality of rows that extend in a first direction based on the netlist, wherein the placing the plurality of cells comprises: placing a first cell and a second cell in a first row among the plurality of rows to be adjacent to each other; and placing a third cell and a fourth cell in a second row among the plurality of rows to be adjacent to each other, wherein the first cell and the second cell respectively comprise a first active pattern and a second active pattern, the first active pattern and the second active pattern extending in the first direction, wherein the third cell and the fourth cell respectively comprise a third active pattern and a fourth active pattern, the third active pattern and the fourth active pattern extending in the first direction, wherein the first active pattern and the second active pattern respectively have different widths in a second direction that is perpendicular to the first direction, and wherein each of the third active pattern and the fourth active pattern has a first width in the second direction.

At least some of the above and other features of the invention are set out in the claims.

### BRIEF DESCRIPTION OF THE DRAWINGS

Embodiments of the inventive concept will be more clearly understood from the following detailed description taken in conjunction with the accompanying drawings in which:
FIGS. 1A and 1B are diagrams showing examples of devices according to some embodiments;
FIGS. 2A and 2B are diagrams showing examples of layouts of integrated circuits according to some embodiments;
FIG. 3 is a diagram showing a layout of an integrated circuit according to some embodiments;
FIG. 4 is a diagram of an integrated circuit according to some embodiments;
FIG. 5 is a diagram showing a layout of an integrated circuit according to some embodiments;
FIGS. 6A and 6B are diagrams showing examples of layouts of integrated circuits according to some embodiments;
FIG. 7 is a flowchart illustrating a method of manufacturing an integrated circuit according to some embodiments;
FIG. 8 is a flowchart illustrating a method of designing an integrated circuit according to some embodiments;
FIG. 9 is a flowchart illustrating a method of designing an integrated circuit according to some embodiments;
FIG. 10 is a diagram showing a layout of an integrated circuit according to some embodiments;
FIG. 11 is a flowchart illustrating a method of designing an integrated circuit according to some embodiments;
FIG. 12 is a block diagram of a system-on-chip (SoC) according to some embodiments; and
FIG. 13 is a block diagram of a computing system including a memory that stores a program according to some embodiments.

### DETAILED DESCRIPTION OF THE INVENTION

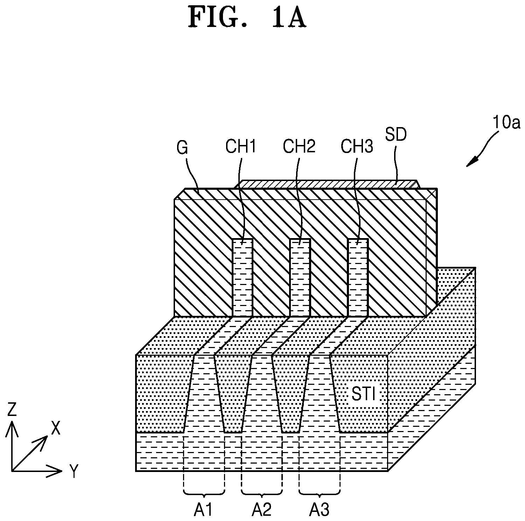

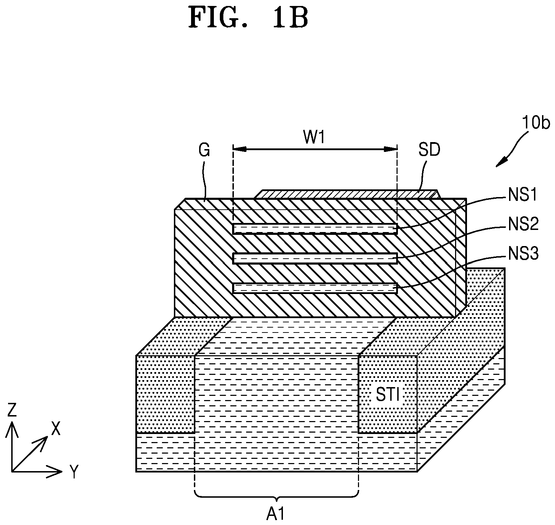

FIGS. 1A and 1B are diagrams showing examples of devices according to some embodiments. In particular, FIG. 1A shows a fin field effect transistor (FinFET) 10a, and FIG. 1B shows a gate-all-around field effect transistor (GAAFET) 10b. For convenience of illustration, in each of FIGS. 1A and 1B one of the two source/drain regions (SD) is omitted from view.

Herein, the X-axis direction and the Y-axis direction may be respectively referred to as a first direction and a second direction, and the Z-axis direction may be referred to as a vertical direction or a third direction. A plane including the X-axis and the Y-axis may be referred to as a horizontal plane, a component arranged in the +Z-axis direction relative to other components may be referred to as being positioned over, on, or above the other components, and a component arranged in the -Z-axis direction relative to other components may be referred to as being positioned below or under the other components. In addition, the area of a component may be referred to as a size that the component occupies on a plane parallel to the horizontal plane, and the width of a component may be referred to as a length of the component in a direction perpendicular to a direction in which the component extends. A surface exposed in the +Z-axis direction may be referred to as a top surface or an upper surface, a surface exposed in the -Z-axis direction may be referred to as a bottom surface or a lower surface, and a surface exposed in the ±X-axis direction or ±Y-axis direction may be referred to as a side surface. It will be appreciated that the directions/orientations defined herein are defined relative to the structure of the device, and therefore need not imply any particular orientation of the device in use. In the drawings, only some layers may be shown for the convenience of illustration, and a via may be displayed in spite of being positioned below a pattern of a wiring layer to show a connection between the pattern of the wiring layer and a lower pattern. In addition, a pattern including a conductive material, such as the pattern of the wiring layer, may be referred to as a conductive pattern, or may also be simply referred to as a pattern.

An integrated circuit may be manufactured by a semiconductor process and may include a plurality of devices. For example, the integrated circuit may include an active device, such as a transistor, or may also include a passive device, such as a capacitor. A semiconductor process may include a series of sub-processes for forming a transistor having a predefined structure. For example, the FinFET 10a and the GAAFET 10b may be formed by semiconductor processes. In some embodiments, the semiconductor processes may include sub-processes of forming transistors having different structures from the FinFET 10a and the GAAFET 10b. For example, a ForkFET having a structure in which an N-type transistor and a P-type transistor have a closer structure may be formed by a semiconductor process by separating nanosheets for the P-type transistor and nanosheets for the N-type transistor with a dielectric wall. In addition, not only an FET such as a complementary FET (CFET), a negative FET (NCFET), a carbon nanotube (CNT) FET, or the like, but also a bipolar junction transistor may be formed by a semiconductor process.

Referring to FIG. 1A, the FinFET 10a may include (e.g., may be formed by) first to third active patterns A1 to A3 each having a fin shape (in a cross-sectional view) and extending between shallow trench isolations (STI) in an X-axis direction and a gate electrode G extending in a Y-axis direction. Source/drain regions SD may be respectively formed on both sides of the gate electrode G (e.g., on opposite sides of the gate electrode G in the X-axis direction), and first to third channels CH1 to CH3 respectively corresponding to the first to third active patterns A1 to A3 may be formed between the source/drain regions SD. For example, the source/drain regions SD may be spaced apart from each other in the X-axis direction with the gate electrode G and the first to third channels CH1 to CH3 therebetween. The first to third channels CH1 to CH3 may overlap the gate electrode G in the Y-axis direction and a Z-axis direction, and an insulating film may be formed between (each of) the first to third channels CH1 to CH3 and the gate electrode G. In some embodiments, the source/drain regions SD may include (three) portions respectively corresponding to the first to third active patterns A1 to A3, which is different from that shown in FIG. 1A. However, the numbers of the active patterns and channels illustrated FIG. 1A are example embodiments and not limited thereto. As used herein, "an element A overlapping an element B in a direction X" (or similar language) means that there is at least one line that extends in the direction X and intersects both the elements A and B.

The FinFET 10a may have a current driving ability corresponding to the number of active patterns (and/or the number of channels). For example, a FinFET including one or two channels may have a lower (less) current driving ability and power consumption than those of the FinFET 10a of FIG. 1A (including three channels, such as the first to third channels CH1 to CH3). In addition, a FinFET including four or more channels may have a higher (greater) current driving ability and power consumption than those of the FinFET 10a of FIG. 1A (including three channels, such as the first to third channels CH1 to CH3). An integrated circuit may include FinFETs including various numbers of channels (and/or various numbers of active patterns) for optimization of performance and efficiency thereof.

Referring to FIG. 1B, the GAAFET 10b may be formed by an active pattern A1 extending in the X-axis direction and a gate electrode G extending in the Y-axis direction. Source/drain regions SD may be respectively formed on both sides of the gate electrode G (e.g., opposite sides of the gate electrode G in the X-axis direction), and first to third nanosheets NS1 to NS3 positioned over (on) the active pattern A1 to be spaced apart from each other in the Z-axis direction, extending in the X-axis direction, and each having a first width W1 (in the Y-axis direction), may form channels between the source/drain regions SD. As shown in FIG. 1B, the GAAFET 10b including nanosheets may be referred to as a multi-bridge channel field effect transistor (MBCFET). For example, the source/drain regions SD may be spaced apart from each other in the X-axis direction with the gate electrode G and the first to third nanosheets NS1 to NS3 therebetween. The first to third nanosheets NS1 to NS3 may overlap the gate electrode G in the Y-axis direction and the Z-axis direction, and an insulating film may be formed between (each of) the first to third nanosheets NS1 to NS3 and the gate electrode G. However, the number of the nanosheets illustrated FIG. 1B is an example embodiment and not limited thereto.

The GAAFET 10b may have a current driving ability corresponding to the number of nanosheets and the width of each of the nanosheets. For example, a GAAFET including one or two nanosheets and/or including nanosheets each having a smaller width than the first width W1 may have a lower (less) current driving ability and power consumption than the GAAFET 10b of FIG. 1B (including three nanosheets, such as first to third nanosheets NS1 to NS3, with the first width W1). In addition, a GAAFET including four or more nanosheets and/or including nanosheets each having a greater width than the first width W1 may have a higher (greater) current driving ability and power consumption than the GAAFET 10b of FIG. 1B (including three nanosheets, such as first to third nanosheets NS1 to NS3, with the first width W1). An integrated circuit may include GAAFETs including nanosheets with various numbers and widths for optimization of performance and efficiency thereof.

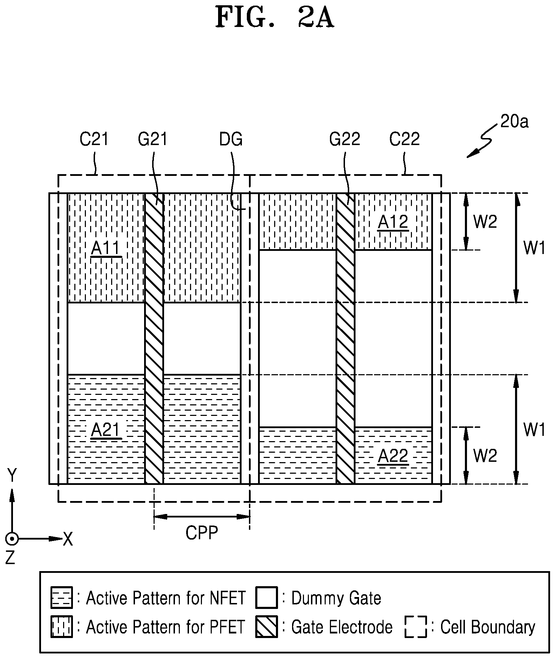

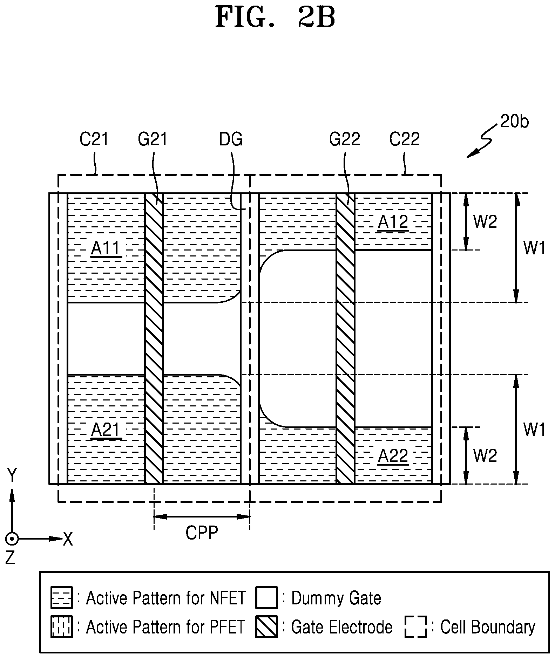

Changing the number and/or width of an active pattern in adjacent devices may be referred to as a transition of the active pattern. A FinFET may implement the transition of an active pattern by adjusting the number of channels, while a GAAFET may implement the transition of an active pattern by adjusting the width of a nanosheet, and accordingly, the GAAFET may support devices with more characteristics (e.g., more variable characteristics) than the FinFET. As to be described below with reference to FIGS. 2A and 2B, when the transition of an active pattern occurs, the devices (i.e., transistors) adjacent to the transition of the active pattern may have different performance from the designed performance.

As to be described below with reference to the drawings, an integrated circuit may be (accurately) designed to have a desired performance despite the transition of the active pattern, and accordingly, the time and cost required to design an integrated circuit may be reduced and the reliability of the integrated circuit may also be improved due to a simple structure thereof. In addition, unnecessary margins may be reduced (e.g., removed) when designing the integrated circuit, and accordingly, the performance of the integrated circuit may increase or be optimized for the desired performance. Hereinafter, a GAAFET, (a MBCFET) is mainly described as an example of a device, but the inventive concept is not limited thereto. In addition, the transition of an active pattern that occurs by changing the width of nanosheets is mainly described, but as described above, the transition of an active pattern may also occur by changing the number of nanosheets.

FIGS. 2A and 2B are diagrams showing examples of layouts of integrated circuits according to some embodiments. For example, FIG. 2A shows a designed layout 20a of an integrated circuit, and FIG. 2B shows a (manufactured) layout 20b of an integrated circuit manufactured by a semiconductor process based on the (designed) layout 20a of FIG. 2A. Gate electrodes (e.g., the first and second gate electrodes G21 and G22) may extend in the Y-axis direction with a contact-poly pitch CPP. Hereinafter, in the descriptions of FIGS. 2A and 2B, the redundant description may be omitted.

Referring to FIG. 2A, the integrated circuit may include a first cell C21 and a second cell C22. A cell is a unit of layout included in the integrated circuit, which may be referred to as a standard cell. The cell may include a transistor and may be designed to perform a predefined function. In the integrated circuit, cells may be aligned and arranged in rows. For example, the first cell C21 and the second cell C22 may be arranged in the same row extending in the X-axis direction. Multiple rows may be spaced apart from each other in the Y-axis direction. Cells arranged in a single row may be referred to as single-height cells, and cells arranged in two or more continuous rows may be referred to as multi-height cells. In some embodiments, a height of a row may refer to a height of a cell therein.

The first cell C21 may include active patterns A11 and A21 extending in the X-axis direction, and the second cell C22 may also include active patterns A12 and A22 extending in the X-axis direction. The active patterns A11 and A12 may provide p-channel field effect transistors (PFET), and the active patterns A21 and A22 may provide n-channel field effect transistors (NFET). For example, the active pattern A11 may cross (e.g., intersect or overlap in the Z-axis direction) a first gate electrode G21 extending in a Y-axis direction and may form a PFET included in the first cell C21. The active pattern A21 may cross (e.g., intersect or overlap in the Z-axis direction) the first gate electrode G21 and may form an NFET included in the first cell C21. The active pattern A12 may cross (e.g., intersect or overlap in the Z-axis direction) a second gate electrode G22 extending in the Y-axis direction and may form a PFET included in the second cell C22. The active pattern A22 may cross (e.g., intersect or overlap in the Z-axis direction) the second gate electrode G22 and form an NFET included in the second cell C22.

Herein, active patterns forming a PFET or an NFET in the same row may be referred to as one active pattern group. For example, the active patterns A11 and A12 providing PFETs may be included in the same active pattern group, and the active patterns A21 and A22 providing NFETs may be included in the same active pattern group. The active patterns included in the same active pattern group may be separated from each other by one or more diffusion breaks (e.g., one or more dummy gates) extending in the Y-axis direction. A diffusion break may be formed of an insulating material (e.g. a wall or barrier of insulating material). The active patterns (e.g. adjacent active patterns in the same active pattern group) may be separated from each other by respective diffusion breaks. For example, the active patterns A11 and A12 may be separated from each other by a dummy gate DG extending in the Y-axis direction, and the dummy gate DG may include an insulating material. In addition, the active patterns A21 and A22 may be separated from each other by the dummy gate DG extending in the Y-axis direction. As shown in FIG. 2A, separating active patterns by filling an insulating material (e.g., by forming the dummy gate DG) with a width (in the X-axis direction) corresponding to one gate electrode (e.g., the first gate G21 or the second gate G22) may be referred to as a single diffusion break (SDB). Unlike shown in FIG. 2A, separating active patterns by filling an insulating material (e.g., by forming the dummy gate DG) with a width (in the X-axis direction) corresponding to a distance between adjacent gate electrodes (e.g., a distance between the first gate G21 and the second gate G22) may be referred to as a double diffusion break (DDB).

The first cell C21 may include an active pattern having a greater width (in the Y-axis direction) than that of the second cell C22. For example, as shown in FIG. 2A, each of the active patterns A11 and A21 included in the first cell C21 may have the first width W1 in the Y-axis direction, while each of the active patterns A12 and A22 included in the second cell C22 may have a second width W2 in the Y-axis direction, and the first width W1 may be greater than the second width W2 (W1>W2). That is, the transition of an active pattern may occur in the dummy gate DG. For example, the transition of an active pattern may occur at and/or adjacent the dummy gate DG (in the view of the horizontal plane). Accordingly, as described above with reference to FIGS. 1A and 1B, the PFET and NFET included in the first cell C21 may have a higher (a greater) current driving ability than that of the PFET and NFET included in the second cell C22. The first cell C21 may have a higher (a faster) operation speed (or lower delay) than the second cell C22 but may have a higher (a greater) power consumption than the second cell C22. The first cell C21 may be used in a portion requiring a high (a faster) operation speed (or low delay) despite the high (the greater) power consumption, and the second cell C22 may be used in a portion that does not require a high (a faster) operation speed, and thus power consumption may be reduced. In some embodiments, unlike shown in FIG. 2A, an active pattern providing a PFET and an active pattern providing an NFET in one cell may have different widths (in the Y-axis direction).

Referring to FIG. 2B, the (manufactured) layout 20b may be formed by a semiconductor process based on the (designed) layout 20a of FIG. 2A. Due to the development of semiconductor processes, the degree of integration of an integrated circuit may be improved and the size of a pattern included in the integrated circuit may be reduced. As the size of the pattern is reduced, the pattern formed by the semiconductor process may have a different shape from the designed pattern. For example, when the transition of an active pattern occurs in (e.g., at and/or adjacent) the dummy gate DG, as shown in FIG. 2B, the widths of the active patterns A11 and A21 of the first cell C21 may decrease around (e.g., at and/or adjacent) the dummy gate DG, and the widths of the active patterns A12 and A22 of the second cell C22 may increase around (e.g., at and/or adjacent) the dummy gate DG. That is, there may be a sloped transition between the first width W1 and the second width W2 around the dummy gate DG. Accordingly, the first cell C21 and the second cell C22 may have different characteristics from the designed characteristics. For example, the PFET and the NFET of the first cell C21 may have a lower (a slower) speed than the designed speed due to the reduced widths of the active patterns A11 and A21, and the PFET and the NFET of the second cell C22 may consume higher (more) power than the designed power due to the increased widths of the active patterns A12 and A22.

A semiconductor design tool may define the operation speed of the first cell C21 as a speed reduced according to the active patterns A11 and A21 having the reduced widths. That is, the integrated circuit may be designed to have margins, and accordingly, the integrated circuit may not be optimized. For example, unlike shown in FIGS. 2A and 2B, when a cell including active patterns having the same width as the active patterns A11 and A21 of the first cell C21 is arranged adjacent to the first cell C21, an operation speed higher (faster) than that of the (manufactured) layout 20b of FIG. 2B may be achieved. As to be described below with reference to the drawings, cells including active patterns with the same width may be arranged in the same row, and accordingly, the transition of an active pattern in the row may be reduced (e.g., removed) and unnecessary margins may be reduced (e.g., removed).

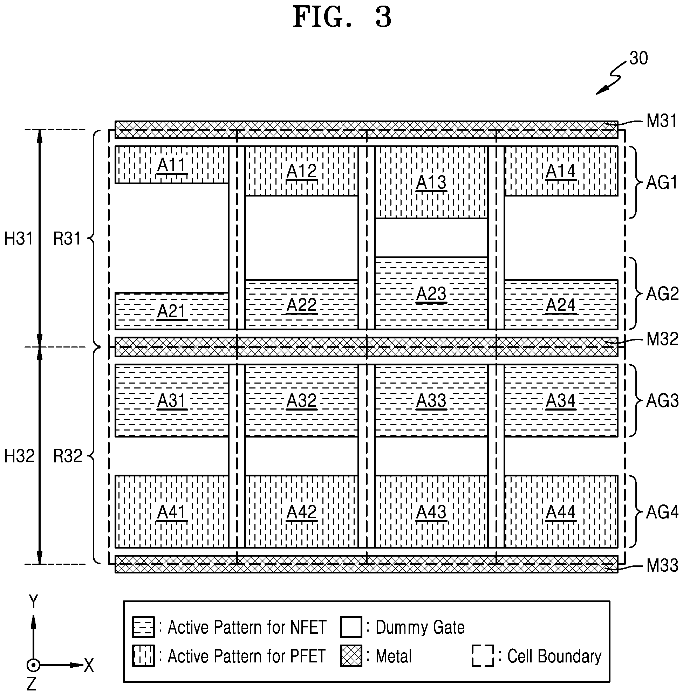

FIG. 3 shows a layout 30 of an integrated circuit according to some embodiments. For example, FIG. 3 shows active patterns separated from each other by (respective) dummy gates extending in the Y-axis direction and metal patterns (extending in the X-axis direction). In some embodiments, the metal patterns may extend over gate electrodes. For example, the metal patterns may overlap with the gate electrodes in the Z-axis direction. For convenience of illustration, the illustration of gate electrodes extending in the Y-axis direction is omitted.

Referring to FIG. 3, a first row R31 and a second row R32 may extend in the X-axis direction. The first row R31 may have a first height H31, and the second row R32 may have a second height H32. The first height H31 and the second height H32 may be the same or different. Herein, the height of a row may refer to a length in a direction perpendicular to the direction in which the row extends, that is, the Y-axis direction (perpendicularly) crossing (intersecting) the X-axis direction. A power line may extend in the X-axis direction along the boundaries of the rows, and a supply voltage for providing power to the devices may be applied to the power line. For example, first to third metal lines M31 to M33 may extend in the X-axis direction along the boundaries of the first row R31 and the second row R32, a positive supply voltage, a negative supply voltage, and the positive supply voltage may be respectively applied to the first to third metal lines M31 to M33. In the first row R31, a first active pattern group AG1 and a second active pattern group AG2 may extend in the X-axis direction, and in the second row R32, a third active pattern group AG3 and a fourth active pattern group AG4 may extend in the X-axis direction.

In the first row R31, each of the first active pattern group AG1 and the second active pattern group AG2 may have a changing width (in the Y-axis direction). For example, the first active pattern group AG1 providing PFETS may include active patterns A11 to A14 separated from each other by (respective) dummy gates extending in the Y-axis direction, and each of the active patterns A11 to A14 may have a specific width, that is, a length in the Y-axis direction. In addition, the second active pattern group AG2 providing NFETs may include active patterns A21 to A24 separated from each other by the (respective) dummy gates extending in the Y-axis direction, and each of the active patterns A21 to A24 may have a specific width, that is, a length in the Y-axis direction.

In the second row R32, each of the third active pattern group AG3 and the fourth active pattern group AG4 may have a constant (e.g., a uniform or the same) width (in the Y-axis direction). For example, the third active pattern group AG3 providing NFETs may include active patterns A31 to A34 separated from each other by (respective) dummy gates extending in the Y-axis direction, and each of the active patterns A31 to A34 may have the same width, that is, a length in the Y-axis direction. In addition, the fourth active pattern group AG4 providing PFETs may include active patterns A41 to A44 separated from each other by the (respective) dummy gates extending in the Y-axis direction, and each of the active patterns A41 to A44 may have the same width, that is, a length in the Y-axis direction. Accordingly, cells arranged in the first row R31 may provide reduced power consumption, while cells arranged in the second row R32 may provide optimal performance by removing margins due to the transition of an active pattern. Herein, as shown in the first row R31, a row in which an active pattern group having a changing width extends may be referred to as an uneven active pattern row, and as shown in the second row R32, a row in which an active pattern group having a constant width extends may be referred to as an even active pattern row. However, the numbers of active patterns, active pattern groups, and rows are not limited to the embodiment illustrated in FIG. 3.

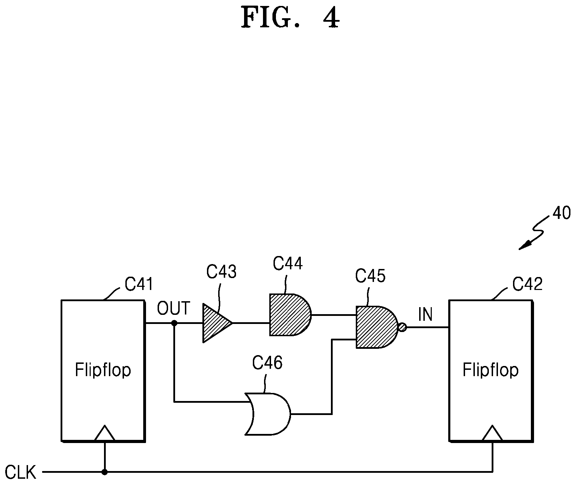

FIG. 4 is a diagram of an integrated circuit 40 according to some embodiments. As shown in FIG. 4, the integrated circuit 40 may include first to sixth cells C41 to C46. As described above with reference to the drawings, the first to sixth cells C41 to C46 may be aligned and arranged in rows in the layout of the integrated circuit 40.

Referring to FIG. 4, the first cell C41 and the second cell C42 may be flip-flops and may commonly receive a clock signal CLK. The third to sixth cells C43 to C46 may be logic gates and may generate an input signal IN of the second cell C42 from an output signal OUT of the first cell C41. Each of the third to sixth cells C43 to C46 may have a specific delay, and the time for generating the input signal IN from the output signal OUT, that is, a propagation delay, may be shorter than a period of the clock signal CLK. In the integrated circuit 40 of FIG. 4, the propagation delay may be determined by a path including the third to fifth cells C43 to C45, and the path including the third to fifth cells C43 to C45, that is, a critical path, may determine the frequency of the clock signal CLK. As described herein, a "critical path" may be a signal path through the integrated circuit (e.g. between an input and an output, e.g. between the output of the first cell C41 and the input of the second cell C42) that has a highest propagation delay (e.g. out of a plurality of signal paths between the input and output). Accordingly, the propagation delay of the critical path may define a minimum clock period. For example, as the propagation delay of the third to fifth cells C43 to C45 decreases, the period of the clock signal CLK may decrease, and the frequency of the clock signal CLK may increase.

In some embodiments, cells (or transistors) included in a critical path may be arranged in a row in which active patterns having a constant width (e.g., the same width) extend. For example, the third to fifth cells C43 to C45 may be arranged in the second row R32 among the first row R31 and the second row R32 in FIG. 3. Accordingly, a timing margin of the third to fifth cells C43 to C45 due to the transition of an active pattern may be removed, and the frequency of the clock signal CLK may increase due to the decreased propagation delay.

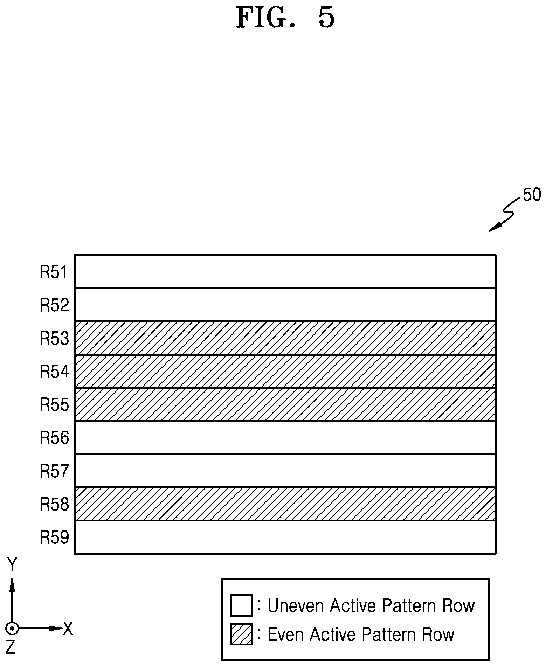

FIG. 5 is a diagram showing a layout 50 of an integrated circuit according to some embodiments. As shown in FIG. 5, in the layout 50 of the integrated circuit, first to ninth rows R51 to R59 may extend in the X-axis direction.

In some embodiments, the layout 50 of the integrated circuit may include at least one uneven active pattern row and at least one even active pattern row. As described herein, an "even pattern row" may be a pattern row in which active patterns have the same width, whereas an "uneven pattern row" may be a pattern row including active patterns with different widths (e.g. with at least two active patterns having different widths). For example, as shown in FIG. 5, the first row R51, the second row R52, the sixth row R56, the seventh row R57, and the ninth row R59 may be uneven active pattern rows, and the third to fifth rows R53 to R55 and the eight row R58 may be even active pattern rows. Accordingly, in each of the first row R51, the second row R52, the sixth row R56, the seventh row R57, and the ninth row R59, active patterns with different widths (in the Y-axis direction) may extend in the X-axis direction, and in each of the third to fifth rows R53 to R55 and the eight row R58, active patterns with the same width (in the Y-axis direction) may extend in the X-axis direction. That is, in each of the first row R51, the second row R52, the sixth row R56, the seventh row R57, and the ninth row R59, cells respectively including active patterns with different widths (in the Y-axis direction) may be arranged, and in each of the third to fifth rows R53 to R55 and the eight row R58, cells respectively including active patterns with the same width (in the Y-axis direction) may be arranged.

The configurations of the even active pattern rows and the uneven active pattern rows may be determined based on the requirements of an integrated circuit. For example, when a propagation delay of a critical path of a designed integrated circuit does not satisfy an operating frequency requirement, an even active pattern row may be added. In addition, when the power consumption of the designed integrated circuit does not satisfy the power consumption requirement, an uneven active pattern row may be added. Accordingly, the integrated circuit may have optimized performance and efficiency.

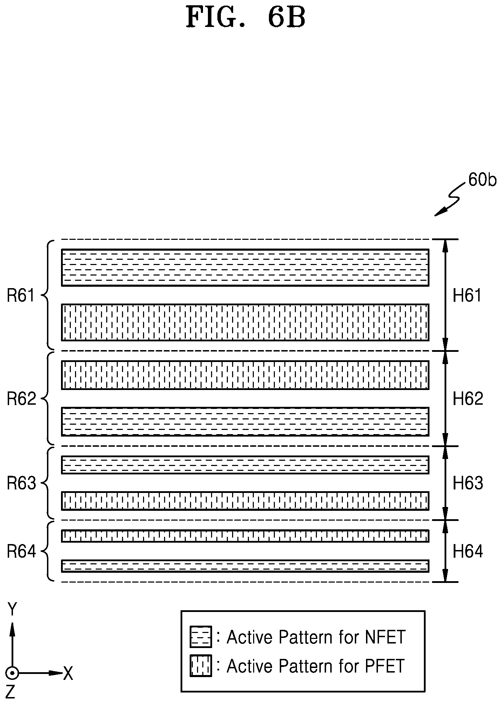

The even active pattern rows and/or the uneven active pattern rows may have the same height or may have different heights. In some embodiments, each of the even active pattern rows may have a first height and each of the uneven active pattern rows may also have the first height. In some embodiments, the integrated circuit may include two or more even active pattern rows having different heights. In some embodiments, as to be described below with reference to FIG. 6B, an integrated circuit may include two or more uneven active pattern rows having different heights.

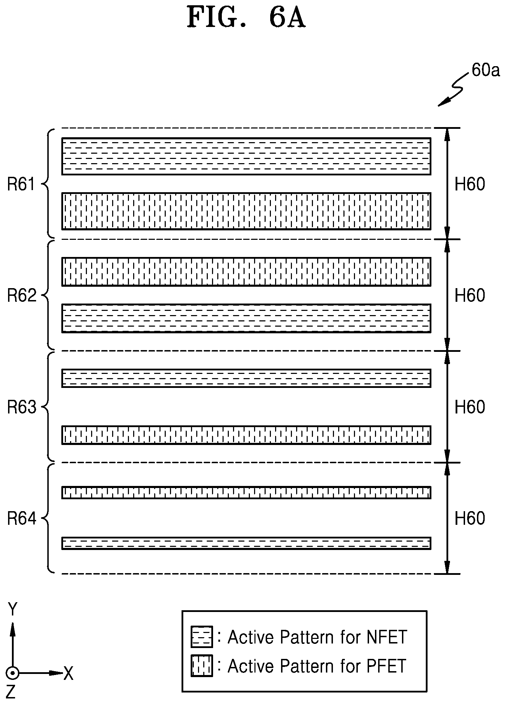

FIGS. 6A and 6B are diagrams showing examples of layouts of integrated circuits according to some embodiments. For example, FIGS. 6A and 6B show layouts 60a and 60b of integrated circuits including active patterns extending in the X-axis direction. For convenience of illustration, the illustration of dummy gates may be omitted in FIGS. 6A and 6B, but as described above with reference to the drawings, the active patterns may be separated by the (respective) dummy gates.

In some embodiments, the layout of an integrated circuit may include even active pattern rows respectively corresponding to active patterns with different widths (in the Y-axis direction). For example, as shown in FIGS. 6A and 6B, each of the layouts 60a and 60b may include first to fourth rows R61 to R64, and the first to fourth rows R61 to R64 may be even active pattern rows. In each of the first to fourth rows R61 to R64, an active pattern with a specific width (in the Y-axis direction) may extend in the X-axis direction. As shown in FIG. 6A, an active pattern with the greatest width may extend in the X-axis direction in the first row R61, an active pattern with the second greatest width may extend in the X-axis direction in the second row R62, an active pattern with the third greatest width may extend in the X-axis direction in the third row R63, and an active pattern with the smallest width may extend in the X-axis direction in the fourth row R64. That is, the widths of the active patterns may decrease with each row. In some embodiments, unlike shown in FIG. 6A, the layout of an integrated circuit may also include only even active pattern rows respectively corresponding to two or three active patterns with different widths (in the Y-axis direction) or may also include even active pattern rows respectively corresponding to more than four active patterns with different widths (in the Y-axis direction).

In some embodiments, the layout of an integrated circuit may include even active pattern rows respectively corresponding to different active patterns and having the same height. For example, as shown in FIG. 6A, in the layout 60a, each of the first to fourth rows R61 to R64 may have the same height H60. In some embodiments, a layout may include even active pattern rows respectively corresponding to different active patterns and having different heights. For example, as shown in FIG. 6B, in the layout 60b, the first to fourth rows R61 to R64 may respectively have first to fourth heights H61 to H64, and the first to fourth heights H61 to H64 may be different from each other. Accordingly, the layout 60b of FIG. 6B may have a smaller area than that of the layout 60a of FIG. 6A. In some embodiments, unlike shown in FIG. 6B, the layout of an integrated circuit may also include only even active pattern rows respectively corresponding to two or three different heights or may also include even active pattern rows respectively corresponding to more than four different heights.

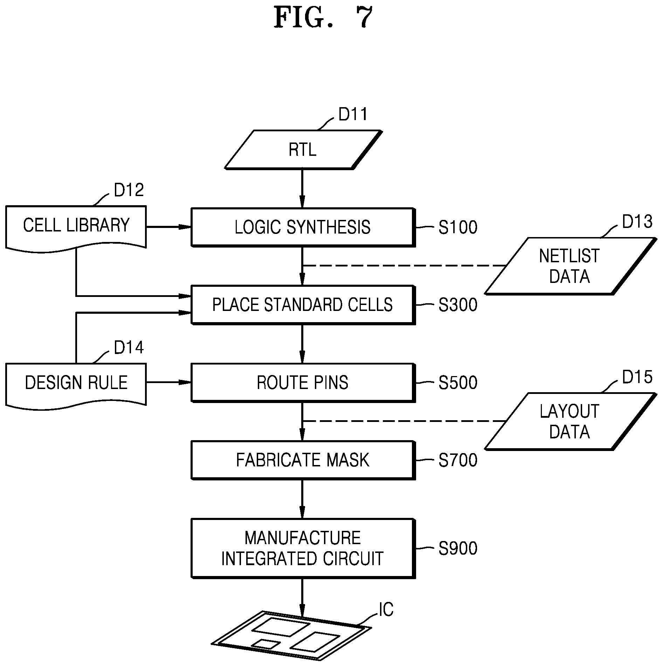

FIG. 7 is a flowchart illustrating a method of manufacturing an integrated circuit IC, according to some embodiments. In particular, FIG. 7 illustrates the method of manufacturing the integrated circuit IC including cells. As shown in FIG. 7, the method of manufacturing the integrated circuit IC may include multiple operations S100, S300, S500, S700, and S900.

A cell library (or standard cell library) D12 may include information about the cells, for example, information about the functions, characteristics, layouts, or the like of the cells. In some embodiments, the cell library D12 may define cells respectively including active patterns with different widths. For example, the cell library D12 may define two or more cells (e.g., AND cells) performing the same function (e.g., AND logic) but respectively including active patterns with different widths. As described above with reference to FIGS. 1A and 1B, a cell including an active pattern with a relatively wide (wider) width may have a higher (faster) operation speed and a greater power consumption than a cell including an active pattern having a relatively narrow (narrower) width. The optimized integrated circuit IC may be designed and manufactured by providing cells respectively corresponding to active patterns with various widths by the cell library D12.

A design rule D14 may include requirements that the layout of the integrated circuit IC must comply with. For example, the design rule D14 may include requirements for a space between patterns on the same layer, the minimum width of a pattern, a routing direction of a wiring layer, or the like. In some embodiments, the design rule D14 may define the minimum width of an active pattern, the minimum space between active patterns, or the like.

In operation S100, a logic synthesis operation of generating netlist data D13 from RTL (register-transfer level) data D11 may be performed. For example, a semiconductor design tool (e.g., a logic synthesis tool) may perform logic synthesis with reference to the cell library D12 from the RTL data D11 written as a hardware description language (HDL), such as a VHSIC hardware description language (VHDL) and Verilog, thereby generating the netlist data D13 including a bitstream or netlist. The netlist data D13 may correspond to an input of place and routing (P&R) to be described below. Here, the netlist data D13 may be referred to as input data.

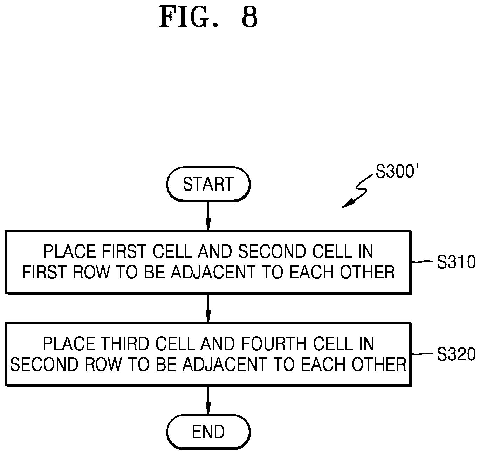

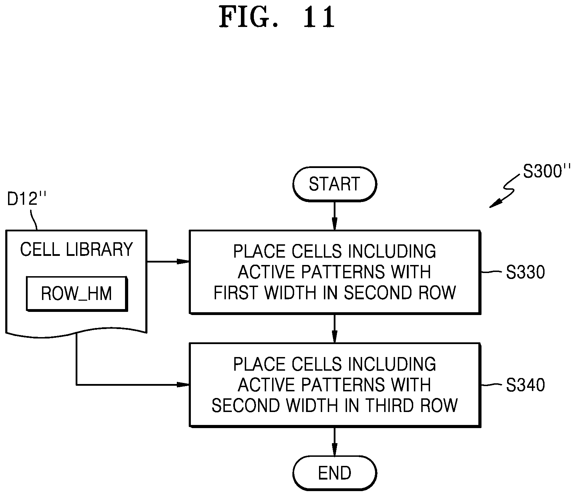

In operation S300, cells may be arranged. For example, a semiconductor design tool (e.g., a P&R tool) may arrange (or place) cells used in the netlist data D13 with reference to the cell library D12 and the design rule D14. Arranging (or placing) cells may comprise defining relative positions and dimensions for the cells. In some embodiments, a semiconductor design tool may add an even active pattern row, and cells corresponding to active patterns with a constant width (e.g., the same width) may be arranged in the even active pattern row. Examples of operation S300 may be described below with reference to FIGS. 8 and 11.

In operation S500, pins of the cells may be routed. For example, a semiconductor design tool may generate interconnections electrically connecting output pins and input pins of the arranged functional cells to each other. In addition, the semiconductor design tool may generate interconnections connected (e.g., electrically connected) to a node to which a positive supply voltage is applied or a node to which a negative supply voltage is applied to provide power to the functional cells. The interconnections may include a via of a via layer and/or a pattern of a wiring layer. A semiconductor design tool may generate layout data D15 defining the arranged cells and the generated interconnections. The layout data D15 may have, for example, a format such as GDSII, and may include geometric information of the cells and the interconnections. A semiconductor design tool may refer to the design rule D14 while routing the pins of the cells. The layout data D15 may correspond to an output of place and routing. Operation S500 alone may be referred to as a method of designing an integrated circuit, or operation S300 and operation S500 may be collectively referred to as a method of designing an integrated circuit.

In operation S700, an operation of fabricating a mask may be performed. For example, an optical proximity correction (OPC) for correcting distortion phenomena, such as refraction due to the characteristics of light in photolithography, may be applied to the layout data D15. Patterns on the mask may be defined to form patterns arranged on a plurality of layers based on the data on which an OPC is applied, and at least one mask (or photomask) for forming patterns of each of the plurality of layers may be fabricated. In some embodiments, the layout of the integrated circuit IC may be modified to a limited extent in operation S700, and the limited modification of the integrated circuit IC in operation S700 is a post-process of optimizing the structure of the integrated circuit IC, which may be referred to as design polishing.

In operation S900, an operation of manufacturing the integrated circuit IC may be performed. For example, the integrated circuit IC may be manufactured by patterning the plurality of layers by using the at least one mask fabricated in operation S700. Front-end-of-line (FEOL) may include, for example, an operation of planarizing and cleaning a wafer, an operation of forming a trench, an operation of forming a well, an operation of forming a gate electrode, and an operation of forming a source and a drain. Through the FEOL, individual devices, for example, transistors, capacitors, resistors, or the like, may be formed on a substrate. In addition, back-end-of-line (BEOL) may include, for example, an operation of performing silicidation on gate, source, and drain regions, an operation of adding a dielectric, an operation of performing planarization, an operation of forming a hole, an operation of adding a metal layer, an operation of forming a via, an operation of forming a passivation layer, or the like. Through the BEOL, individual devices, for example, transistors, capacitors, resistors, or the like, may be connected (e.g., electrically connected) to each other. In some embodiments, a middle-of-line (MOL) may be performed between the FEOL and the BEOL, and contacts may be formed on the individual devices. Then, the integrated circuit IC may be packaged in a semiconductor package and may be used as a part of various applications. However, the operation of manufacturing the integrated circuit IC (the operation S900) is not limited to the above-noted processes.

FIG. 8 is a flowchart illustrating a method of designing an integrated circuit according to some embodiments. For example, the flowchart (the operation S300') of FIG. 8 shows an example of operation S300 of FIG. 7. As described above with reference to FIG. 7, cells may be arranged in operation S300' of FIG. 8. As shown in FIG. 8, operation S300' may include operation S310 and operation S320.

Referring to FIG. 8, in operation S310, a first cell and a second cell may be arranged adjacent to each other in a first row. For example, as described above with reference to FIG. 3, the first row may be an uneven active pattern row, and a semiconductor design tool may arrange (or place) the first cell and the second cell respectively including active patterns with different widths in the first row. As described above with reference to FIG. 2B, the transition of an active pattern may occur at (and/or adjacent) the boundary of the first cell and the second cell, but the first cell and the second cell may be irrelevant (or less relevant) to the performance of the integrated circuit, for example, the critical path, and thus may not affect (or may less affect) the performance of the integrated circuit.

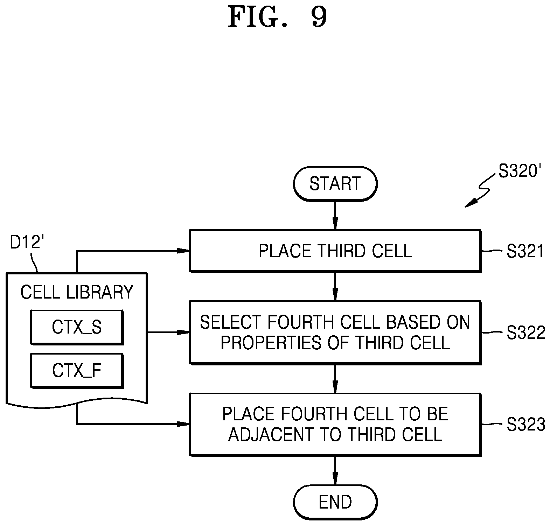

In operation S320, a third cell and a fourth cell may be arranged adjacent to each other in a second row. In some embodiments, as described above with reference to FIG. 3, the second row may be an even active pattern row, and a semiconductor design tool may arrange (or place) the third cell and the fourth cell respectively including active patterns with the same width in the second row. In some embodiments, as to be described below with reference to FIG. 9, the second row may be an even active pattern row, and a semiconductor design tool may arrange (or place) the third cell and the fourth cell respectively including active patterns with the same width in the second row. The transition of an active pattern may not occur between the third cell and the fourth cell, and the third cell and the fourth cell may provide the performance in which a margin is reduced (e.g., removed). As described above with reference to FIG. 4, when the third cell and the fourth cell are included in a critical path, the operation speed of the integrated circuit or the frequency of a clock signal may increase. Whilst the method of FIG. 8 shows one order of placing, embodiments are not necessarily limited to this order, for instance, the third and fourth cells may be placed before the first and second cells. An example of operation S320 may be described below with reference to FIG. 9.

FIG. 9 is a flowchart illustrating a method of designing an integrated circuit according to some embodiments. For example, the flowchart (the operation S320') of FIG. 9 shows an example of operation S320 of FIG. 8. As described above with reference to FIG. 8, in operation S320' of FIG. 9, a third cell and a fourth cell may be arranged adjacent to each other in a second row. As shown in FIG. 9, operation S320' may include multiple operations S321 to S323. Hereinafter, FIG. 9 is described with reference to FIG. 7.

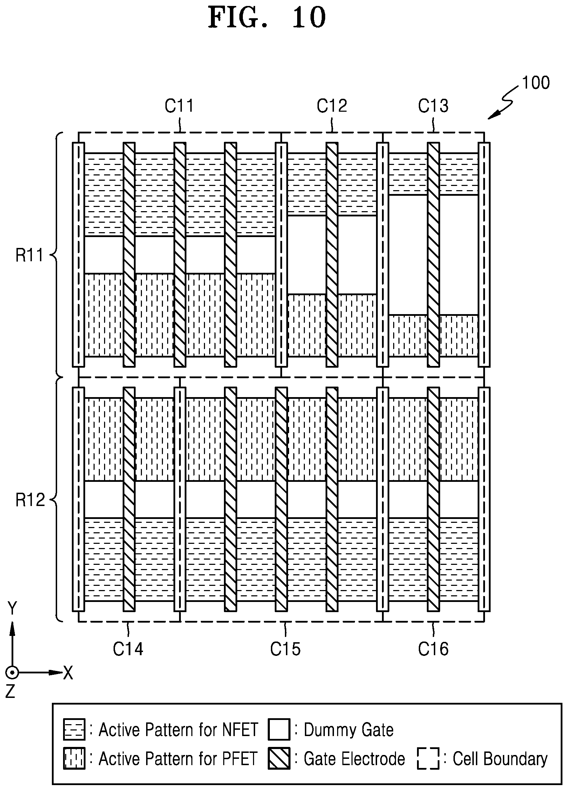

Referring to FIG. 9, the third cell may be arranged in operation S321. For example, the netlist data D13 of FIG. 7 may define the third cell, and a semiconductor design tool may arrange (or place) the third cell in the second row with reference to a cell library D12'. For example, the cell library D12' of FIG. 9 may correspond to the cell library D12 of FIG. 7. In some embodiments, the cell library D12' may define the third cell as a sensitive cell. For example, as shown in FIG. 9, the cell library D12' may define a context-sensitive cell group CTX_S and a context-free cell group CTX_F. The context-sensitive cell group CTX_S may include cells that require cells including active patterns with the same width to be arranged adjacent to each other in the same row, that is, a context-sensitive cell. In addition, the context-free cell group CTX_F may include a cell that does not limit cells to be arranged adjacent to each other in the same row, that is, a context-free cell. The context-sensitive cell group CTX_S and the context-free cell group CTX_F may respectively define a context-sensitive cell (e.g., C14 of FIG. 10) and a context-free cell (e.g., C11 of FIG. 10), which correspond to the layout having the same structure. Despite the same layout, the context-sensitive cell may provide higher performance than that of the context-free cell due to a low-performance margin. In some embodiments, the netlist data D13 may define the context-sensitive cell as a cell included in a critical path and may define the context-free cell as a cell that is not included in the critical path.

In operation S322, the fourth cell may be selected based on the properties of the third cell. As described above, the third cell may be a context-sensitive cell, and the fourth cell may be referred to as a cell to be arranged adjacent to the third cell in the second row. Context-sensitive cells may have properties indicating that the context-sensitive cells are included in the context-sensitive cell group CTX_S, and context-free cells may have properties indicating that the context-free cells are included in the context-free cell group CTX_F. A semiconductor design tool may select the fourth cell based on the properties of the third cell, that is, the properties indicating that the third cell is a context-sensitive cell. For example, the semiconductor design tool may select, from the netlist data D13, the fourth cell including active patterns with the same width as the width of active patterns included in the third cell.

In some embodiments, when an appropriate cell is not selected from the netlist data D13, a semiconductor design tool may select a dummy cell as the fourth cell. For example, the context-free cell group CTX_F of the cell library D12' may include dummy cells respectively corresponding to active patterns with various widths. When an appropriate cell to be arranged adjacent to the third cell may not be selected from the netlist data D13, a semiconductor design tool may select a dummy cell included in the context-free cell group CTX_F and including active patterns with the same width as that of the third cell as the fourth cell.

In some embodiments, when an appropriate cell may not be selected from the netlist data D13, a semiconductor design tool may select one of the cells defined in the netlist data D13, and the selected cell may include an active pattern with a smaller width than that of the third cell. The semiconductor design tool may identify, from the cell library D12', the fourth cell providing the same function as the selected cell and including an active pattern with the same width as that of the third cell and may replace the selected with the fourth cell, thereby selecting the fourth cell.

In operation S323, the fourth cell may be arranged adjacent to the third cell. For example, a semiconductor design tool may arrange (or place) the fourth cell selected in operation S322 adjacent to the third cell in the second row in which the third cell is arranged. Because the third cell and the fourth cell include active patterns with the same width, the transition of an active pattern may not occur between the third cell and the fourth cell. Accordingly, the performance of the third cell, which is a context-sensitive cell, may be improved (e.g., guaranteed).

FIG. 10 is a diagram showing a layout 100 of an integrated circuit according to some embodiments. For example, FIG. 10 shows the layout 100 of an integrated circuit designed according to the method of FIG. 9. As shown in FIG. 10, in the layout 100, a first row R11 and a second row R12 may extend in the X-axis direction. First to third cells C11 to C13 may be arranged in the first row R11, and fourth to sixth cells C14 to C16 may be arranged in the second row R12. Hereinafter, FIG. 10 is described with reference to FIG. 9.

The first cell C11 and the fifth cell C15 may have the same designed layout, while the first cell C11 may be included in the context-free cell group CTX_F, and the fifth cell C15 may be included in the context-sensitive cell group CTX_S. The semiconductor design tool may identify a context-free cell from the properties of the first cell C11, and may arrange (or place) a cell including an active pattern with a different width (in the Y-axis direction) from that of the first cell C11, that is, the second cell C12, adjacent to the first cell C11. In some embodiments, unlike shown in FIG. 10, a cell including an active pattern with the same width (in the Y-axis direction) as that of the first cell C11 may also be arranged adjacent to the first cell C11. The second cell C12 adjacent to the first cell C11 may also be a context-free cell, and a cell including an active pattern with a different width (in the Y-axis direction) from that of the second cell C12, that is, the third cell C13, may be arranged adjacent to the second cell C12.

The semiconductor design tool may identify a context-sensitive cell from the properties of the fifth cell C15, and may arrange (or place) cells including active patterns with the same width (in the Y-axis direction) as that of the fifth cell C15, that is, the fourth cell C14 and the sixth cell C16, adjacent to the fifth cell C15. Accordingly, the first cell C11 and the fifth cell C15 may provide different performances despite the first cell C11 and the fifth cell C15 corresponding to the same designed layout. The fourth cell C14 and/or the sixth cell C16 arranged adjacent to the fifth cell C15 may also be context-sensitive cells or context-free cells. Accordingly, cells having the same width may be placed on one or both sides of a context-sensitive cell, but these cells may be context-free cells, and therefore the width of further cells within the row may vary.

FIG. 11 is a flowchart illustrating a method of designing an integrated circuit according to some embodiments. For example, the flowchart (the operation S300") of FIG. 11 shows an example of operation S300 of FIG. 7. As described above with reference to FIG. 7, cells may be arranged in operation S300" of FIG. 11. As shown in FIG. 11, operation S300" may include operation S330 and operation S340.

Referring to FIG. 11, in operation S330, cells including active patterns with a first width may be arranged in a second row. For example, the layout of the integrated circuit may include even active pattern rows and uneven active pattern rows, as described above with reference to FIG. 5. The second row may be an even active pattern row, and the active patterns with the first width may extend in the second row. In some embodiments, a cell library D12" may define a cell group ROW_HM including cells arranged in an even active pattern row. The semiconductor design tool may identify cells included in the cell group ROW_HM from the netlist data D13 of FIG. 7, and may arrange (or place) cells including active patterns with the first width among the identified cells in the second row. Accordingly, the transition of an active pattern may be omitted in the second row, and the cells arranged in the second row may provide high performance (e.g., relatively improved performance than the cells with a margin) in which a margin is reduced (e.g., removed).

In operation S340, cells including active patterns with a second width may be arranged in a third row, and the second width may be different from the first width. For example, the third row may be an even active pattern row, and the active patterns with the second width may extend in the third row. A semiconductor design tool may identify cells included in the cell group ROW_HM from the netlist data D13, and may arrange (or place) cells including active patterns with the second width among the identified cells in the third row. Accordingly, the transition of an active pattern may be omitted in the third row, and the cells arranged in the third row may provide high performance (e.g., relatively improved performance than the cells with a margin) in which a margin is reduced (e.g., removed).

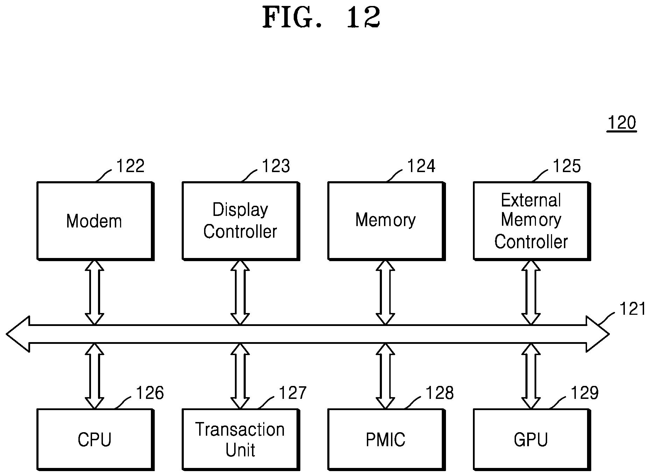

FIG. 12 is a block diagram of a system-on-chip (SoC) 120 according to some embodiments. The SoC 120 is a semiconductor device, which may include an integrated circuit according to some embodiments. The SoC 120 may implement complex blocks, such as intellectual properties (IP) performing various functions, on one chip, and the SoC 120 may be designed by a method of designing an integrated circuit according to embodiments, and thus the SoC 120 may provide high (improved) performance and reliability. Referring to FIG. 12, the SoC 120 may include a modem 122, a display controller 123, a memory 124, an external memory controller 125, a central processing unit (CPU) 126, a transaction unit 127, a power management integrated circuit (PMIC) 128, and a graphics processing unit (GPU) 129, and functional blocks of the SoC 120 may communicate with each other through a system bus 121. The SoC 120 illustrated in FIG. 12 is an example embodiment, and the inventive concepts of the SoC 120 are not limited thereto. As used hereinafter, the terms "external/outside configuration", "external/outside device", "external/outside power", "external/outside signal", or "outside" are intended to broadly refer to a device, circuit, block, module, power, and/or signal that resides externally (e.g., outside of a functional or physical boundary) with respect to a given circuit, block, module, system, or device.

The CPU 126 capable of controlling the operation of the SoC 120 in the uppermost layer may control the operations of other functional blocks (e.g., the modem 122, the display controller 123, the memory 124, the external memory controller 125, the transaction unit 127, the PMIC 128, and the GPU 129). The modem 122 may demodulate a signal received from the outside of the SoC 120 or may modulate a signal generated inside the SoC 120 and transmit the modulated signal to the outside. The external memory controller 125 may control an operation of transmitting and receiving data to and from an external memory device connected (e.g., electrically connected) to the SoC 120. For example, a program and/or data stored in the external memory device may be provided to the CPU 126 or the GPU 129 under the control by the external memory controller 125. The GPU 129 may execute program instructions related to graphics processing. The GPU 129 may receive graphic data through the external memory controller 125 and may also transmit graphic data processed by the GPU 129 to the outside of the SoC 120 through the external memory controller 125. The transaction unit 127 may monitor data transactions of each of the functional blocks, and the PMIC 128 may control power supplied to each function block under the control by the transaction unit 127. The display controller 123 may transmit data generated in the SoC 120 to a display by controlling the display (or a display device) outside the SoC 120. The memory 124 may include non-volatile memory, such as electrically erasable programmable read-only memory (EEPROM), flash memory, or the like, or may also include volatile memory such as dynamic random-access memory (DRAM), static random-access memory (SRAM), or the like.

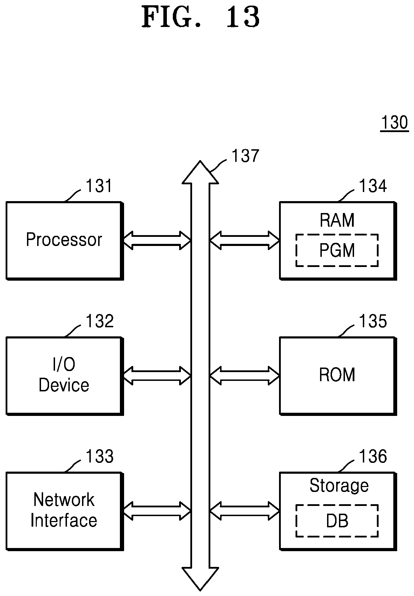

FIG. 13 is a block diagram of a computing system 130 including a memory that stores a program according to some embodiments. The method of designing an integrated circuit according to embodiments, for example, at least some of the operations in the flowcharts described above, may be performed by the computing system 130 (or a computer). For instance, in the embodiment of FIG. 7, steps S100, S300 and S500 may be performed by the computing system 130. In addition, steps S700 and S900 of FIG. 7 may be controlled by a computing system (e.g. that issues instructions to semiconductor fabrication equipment). Similarly, the methods of FIGs. 8, 9 and 11 may be performed by the computing system 130. The computing system 130 may be configured to generate a design for an integrated circuit according to the methods described herein. The computing system 130 may be configured to generate computer executable instructions (e.g. computer numerical control instructions) for controlling manufacturing equipment to manufacture the integrated circuit according to the design. The computer executable instructions may be output to control the manufacturing equipment to manufacture the integrated circuit according to the design. Alternatively or in addition, the computer executable instructions may be stored for later use in controlling the manufacturing equipment to manufacture the integrated circuit according to the design.

The computing system 130 may be a stationary computing system such as a desktop computer, a workstation, a server, or the like, or may be a portable computing system such as a laptop computer or the like. As shown in FIG. 13, the computing system 130 may include a processor 131, input/output (I/O) devices 132, a network interface 133, random-access memory (RAM) 134, read-only memory (ROM) 135, and a storage 136. The processor 131, the I/O device 132, the network interface 133, the RAM 134, the ROM 135, and the storage 136 may be connected (e.g., electrically connected) to a bus 137 and may communicate with each other through the bus 137.

The processor 131 may be referred to as a processing unit and may include, for example, at least one core capable of executing any instruction set (e.g., Intel Architecture-32 (IA-32), 64-bit expansion IA-32, x86-64, PowerPC, Sparc, MIPS, ARM, IA-64, or the like), such as a microprocessor, an application processor (AP), a digital signal processor (DSP), or a GPU. For example, the processor 131 may access memory, that is, the RAM 134 and/or the ROM 135, through the bus 137 and may execute instructions stored in the RAM 134 and/or the ROM 135.

The RAM 134 may store a program PGM for the method of designing an integrated circuit according to some embodiments or at least a portion of the program PGM, and the program PGM may cause the processor 131 to perform the method of designing an integrated circuit, for example, at least some of the operations included in the method of FIG. 9. That is, the program PGM may include a plurality of instructions that may be executable by the processor 131, and the plurality of instructions included in the program PGM may cause the processor 131 to perform, for example, at least some of the operations included in the flowcharts described above.

The storage 136 may not lose stored data even when power supplied to the computing system 130 is cut off. For example, the storage 136 may include a non-volatile memory device, or may also include a storage medium such as magnetic tape, an optical disk, and a magnetic disk. In addition, the storage 136 may also be detachable from the computing system 130. The storage 136 may store the program PGM according to some embodiments, and the program PGM or at least a portion of the program PGM may be loaded to the RAM 134 from the storage 136 before being executed by the processor 131. In some embodiments, the storage 136 may store a file written in a program language, and the program PGM or at least a portion of the program PGM generated by a compiler or the like may be loaded to the RAM 134 from the file. In addition, as shown in FIG. 13, the storage 136 may store a database DB, and the database DB may include information required for designing an integrated circuit, for example, information about designed blocks, and the cell library D12, and/or the design rule D14 of FIG. 7.

The storage 136 may store data to be processed by the processor 131 or data processed by the processor 131. That is, the processor 131 may generate data by processing data stored in the storage 136 according to the program PGM and may also store the generated data in the storage 136. For example, the storage 136 may store the RTL data, the netlist data D13, and/or the layout data D15 of FIG. 7.

The I/O devices 132 may include an input device such as a keyboard, a pointing device, or the like and may include an output device such as a display device, a printer, or the like. For example, a user may trigger the execution of the program PGM by the processor 131, input the RTL data D 11, and/or the netlist data D13 of FIG. 7, and also check the layout data D15 of FIG. 7 through the I/O devices 132.

The network interface 133 may provide access to a network outside the computing system 130. For example, the network may include multiple computing systems and communication links, and the communication links may include wired links, optical links, wireless links, or any other forms of links.

While the inventive concept has been particularly shown and described with reference to embodiments thereof, it will be understood that various changes in form and details may be made therein without departing from the scope of the following claims.

## Claims

1. An integrated circuit comprising:
a plurality of first gate electrodes extending in a second direction that is perpendicular to a first direction, wherein the plurality of first gate electrodes is in a first row that extends in the first direction;
a first active pattern group comprising a plurality of first active patterns that extend in the first row in the first direction and intersecting the plurality of first gate electrodes;
a plurality of second gate electrodes extending in the second direction in a second row that extends in the first direction; and
a second active pattern group comprising a plurality of second active patterns that extend in the second row in the first direction and intersecting the plurality of second gate electrodes,
wherein ones of the plurality of first active patterns have different widths in the second direction, and
wherein ones of the plurality of second active patterns have a first width in the second direction.

2. The integrated circuit of claim 1, wherein ones of the plurality of first active patterns are separated from each other by respective ones of a plurality of first diffusion breaks that extend in the second direction in the first row, and
wherein ones of the plurality of second active patterns are separated from each other by respective ones of a plurality of second diffusion breaks that extend in the second direction in the second row.

3. The integrated circuit of claim 1 or claim 2, wherein ones of the plurality of first active patterns have different widths, and
wherein ones of the plurality of second active patterns each have the first width in the second direction.

4. The integrated circuit of any preceding claim, further comprising:
a plurality of third gate electrodes extending in the second direction in a third row that extends in the first direction; and
a third active pattern group comprising a plurality of third active patterns that extend in the third row in the first direction and intersecting the plurality of third gate electrodes,
wherein ones of the plurality of third active patterns have a second width in the second direction, and
wherein the second width is different from the first width.

5. The integrated circuit of claim 4, wherein ones of the plurality of third active patterns are separated from each other by respective third diffusion breaks that extend in the second direction in the third row, and
wherein ones of the plurality of third active patterns each have the second width.

6. The integrated circuit of any preceding claim, further comprising a fourth active pattern group comprising a plurality of fourth active patterns that extend in the first direction in the second row and cross the plurality of second gate electrodes,
wherein the plurality of second gate electrodes and the plurality of second active patterns provide a plurality of n-channel field effect transistors, NFETs,
wherein the plurality of second gate electrodes and the plurality of fourth active patterns provide a plurality of p-channel field effect transistors, PFETs, and
wherein ones of the plurality of fourth active patterns each have a third width in the second direction.

7. The integrated circuit of any preceding claim, wherein at least one of the plurality of second gate electrodes and the plurality of second active patterns provide at least one transistor included in a critical path of the integrated circuit.

8. The integrated circuit of any preceding claim, wherein the first row has a first height in the second direction,
wherein the second row has a second height in the second direction, and
wherein the first height is equal to the second height.

9. The integrated circuit of any of claims 1-7, wherein the first row has a first height in the second direction,
wherein the second row has a second height in the second direction, and
wherein the first height is different from the second height.

10. A method of manufacturing an integrated circuit comprising a plurality of cells, the method comprising:
obtaining a netlist defining the plurality of cells; and
placing the plurality of cells in a plurality of rows that extend in a first direction based on the netlist,
wherein the placing the plurality of cells comprises:
placing a first cell and a second cell in a first row among the plurality of rows to be adjacent to each other; and
placing a third cell and a fourth cell in a second row among the plurality of rows to be adjacent to each other,
wherein the first cell and the second cell respectively comprise a first active pattern and a second active pattern, the first active pattern and the second active pattern extending in the first direction,
wherein the third cell and the fourth cell respectively comprise a third active pattern and a fourth active pattern, the third active pattern and the fourth active pattern extending in the first direction,
wherein the first active pattern and the second active pattern respectively have different widths in a second direction that is perpendicular to the first direction, and
wherein each of the third active pattern and the fourth active pattern has a first width in the second direction.

11. The method of claim 10, wherein the placing the third cell and the fourth cell comprises:
selecting the fourth cell based on properties of the third cell; and
placing the fourth cell to be adjacent to the third cell.

12. The method of claim 10 or claim 11, wherein the placing the plurality of cells further comprises placing, in the second row, a first group of cells among the plurality of cells with active patterns having the first width in the second direction.

13. The method of claim 12, wherein the placing the plurality of cells further comprises placing, in a third row, a second group of cells among the plurality of cells with active patterns having a second width in the second direction, and
wherein the second width is different from the first width.

14. The method of any of claims 10-13, wherein at least one of the third cell and the fourth cell is included in a critical path of the integrated circuit.

15. The method of any of claims 10-14, further comprising:
generating layout data defining a layout of the integrated circuit;
fabricating a mask based on the layout data; and
manufacturing the integrated circuit based on the mask.
